# EUROPEAN PATENT APPLICATION

(11) **EP 4 752 571 A1**
(43) Date of publication of application: **03.06.2026**
(21) Application number: 25219026.9
(22) Date of filing: 27.11.2025
(51) Int. Cl.: G01R 31/00, G01R 31/327, G01R 31/396

(54) **BATTERY MONITORING SYSTEM AND METHOD**

(30) Priority: 27.11.2024 US 202418963057
(71) Applicant: Pratt & Whitney Canada Corp., (01BE5) Longueuil, QC J4G 1A1 (CA)
(72) Inventor: FREER, Richard, (01BE5) Longueuil, J4G 1A1 (CA)
(74) Representative: Dehns

(57) **Abstract**

A method of monitoring a battery system (42) utilized within an aircraft propulsion system is provided that includes: providing a parallel electrical circuit having a first and second battery units (38A, 38B) and first and second electrical contactors (60A, 60B) disposed in a parallel electrical circuit, positive and negative bus connectors (60A, 60B) electrically connected to first and second legs of the circuit, and an electrical device (34) electrically connected to the positive and negative bus connectors (56, 58). The method further includes controlling the first and second electrical contactors (60A, 60B) to be in a closed configuration; using a first voltage sensor (62A) to determine a first voltage across the first battery unit (38A); using a second voltage sensor (62B) to determine a second voltage across the second battery unit (38B); using a bus voltage sensor (66) to determine a bus voltage between the positive and negative bus connectors (56, 58); and monitoring the battery system (42) using the first, second, and bus voltages.

## Description

### BACKGROUND OF THE INVENTION

### 1. Technical Field

The present disclosure relates generally to aircraft propulsion systems in general and to battery management systems (BMS) and methods for aircraft propulsion systems.

### 2. Background Information

Propulsion system architectures for aircraft, such as hybrid-electric propulsion systems, may typically include one or more electrical assemblies configured to support various functions of the propulsion system and an associated aircraft. These electrical assemblies may frequently include batteries configured to provide electrical power for various electrical loads of the aircraft and its propulsion system(s). Various systems and methods for monitoring battery operations are known. While these known systems and methods may be suitable for their intended purposes, there is always room in the art for improvement.

### SUMMARY

According to an aspect of the present disclosure, a method of monitoring a battery system utilized within an aircraft propulsion system is provided that includes: providing a parallel electrical circuit having a first battery unit and a first electrical contactor disposed in a first leg of the parallel electrical circuit, a second battery unit and a second electrical contactor disposed in a second leg of the parallel electrical circuit, a positive bus connector electrically connected to the first leg and the second leg, a negative bus connector electrically connected to the first leg and the second leg, and an electrical device electrically connected to the positive bus connector and the negative bus connector, and controllable to draw electrical current through the parallel electrical circuit; wherein the first electrical contactor (FEC) is controllable to be in an FEC closed configuration and an FEC open configuration; and wherein the second electrical contactor (SEC) is controllable to be in an SEC closed configuration and an SEC open configuration; and controlling the first electrical contactor to be in the FEC closed configuration, and controlling the second electrical contactor to be in the SEC closed configuration; using a first voltage sensor to determine a first voltage across the first battery unit within the first leg when the first electrical contactor is in the FEC closed configuration; using a second voltage sensor to determine a second voltage across the second battery unit within the second leg when the second electrical contactor is in the SEC closed configuration; and monitoring the battery system by determining a first difference between the first voltage and the second voltage, and producing a fault indicator if the first difference or the second difference exceeds a predetermined threshold.

In any of the above and herein, the first electrical contactor may be disposed in the first leg between the first battery unit and the positive bus connector, and the second electrical contactor may be disposed in the second leg between the second battery unit and the positive bus connector.

In any of the described above and herein, the first voltage sensor may be in electrical communication with the first leg between a pole of the first battery and the first electrical contactor, and the second voltage sensor may be in electrical communication with the second leg between a pole of the second battery and the second electrical contactor.

In any of the above and herein, the method may include using a bus voltage sensor to determine a bus voltage between the positive bus connector and the negative bus connector, and determining a first contactor voltage by subtracting the first voltage from the bus voltage.

In any of the above and herein, the method may include determining a first contactor resistance by sensing a first leg current using a first leg current sensor, and dividing the first contactor voltage by the first leg current.

In any of the above and herein, the method may include using a bus voltage sensor to determine a bus voltage between the positive bus connector and the negative bus connector, and determining a second contactor voltage by subtracting the second voltage from the bus voltage.

In any of the above and herein, the method may include determining a second contactor resistance by sensing a second leg current using a second leg current sensor, and dividing the second contactor voltage by the second leg current.

In any of the above and herein, the first electrical contactor may be disposed in the first leg between the first electrical contactor and the positive bus connector or between the first battery unit and the negative bus connector, and the second electrical contactor may be disposed in the second leg between the second battery unit and the positive bus connector or between the second battery unit and the negative bus connector.

In any of the above and herein, the first electrical contactor may be disposed in the first leg between the first battery unit and the negative bus connector, and the second electrical contactor may be disposed in the second leg between the second battery unit and the negative bus connector.

In any of the above and herein, the first voltage sensor may be in electrical communication with the first leg between a pole of the first battery and the first electrical contactor, and the second voltage sensor may be in electrical communication with the second leg between a pole of the second battery and the second electrical contactor.

In any of the aspcts or embodiments described above and herein, the method may include controlling the electrical device to draw electrical current through the parallel electrical circuit, and a bus voltage sensor may be used to determine a bus voltage when the electrical device is drawing electrical current through the parallel electrical circuit.

According to another aspect of the present disclosure, a method of inspecting electrical contactors in a battery system utilized within an aircraft propulsion system is provided. The battery system includes a parallel electrical circuit having a first battery unit and a first electrical contactor disposed in a first leg of the parallel electrical circuit, a second battery unit and a second electrical contactor disposed in a second leg of the parallel electrical circuit, a positive bus connector electrically connected to the first leg and the second leg, a negative bus connector electrically connected to the first leg and the second leg, and an electrical device electrically connected to the positive bus connector and the negative bus connector, and controllable to draw electrical current through the parallel electrical circuit. The method includes: controlling the first electrical contactor (FEC) to be in an FEC closed configuration, and controlling the second electrical contactor (SEC) to be in an SEC closed configuration; using a first voltage sensor to determine a first voltage across the first battery unit within the first leg when the electrical device is drawing electrical current through the parallel electrical circuit; using a second voltage sensor to determine a second voltage across the second battery unit within the second leg; using a bus voltage sensor to determine a bus voltage between the positive bus connector and the negative bus connector; determining a first contactor voltage using the first voltage and the bus voltage; and determining a second contactor voltage using the second voltage and the bus voltage.

In any of the above and herein, the method may include producing a fault indicator if the first contactor voltage or the second contactor voltage exceeds a predetermined threshold.

According to another aspect of the present disclosure, a method of inspecting electrical contactors in a battery system utilized within an aircraft propulsion system. The battery system includes a parallel electrical circuit having a first battery unit and a first electrical contactor disposed in a first leg of the parallel electrical circuit, a second battery unit and a second electrical contactor disposed in a second leg of the parallel electrical circuit, a positive bus connector electrically connected to the first leg and the second leg, a negative bus connector electrically connected to the first leg and the second leg, and an electrical device electrically connected to the positive bus connector and the negative bus connector, and controllable to draw electrical current through the parallel electrical circuit. The method includes: using a first voltage sensor to determine a first closed contactor voltage across the first battery unit within the first leg when the first electrical contactor (FEC) is in an FEC closed configuration; using a second voltage sensor to determine a second closed contactor voltage across the second battery unit within the second leg when the second electrical contactor (SEC) is in an FEC closed configuration; using the first voltage sensor to determine a first open contactor voltage across the first battery unit within the first leg when the first electrical contactor is in an FEC open configuration; using the second voltage sensor to determine a second open contactor voltage across the second battery unit within the second leg when the second electrical contactor is in an SEC open configuration; using a bus voltage sensor to determine a bus voltage between the positive bus connector and the negative bus connector; inspecting a first contactor position by comparing the first closed contactor voltage and the first contactor open voltage to the bus voltage; and inspecting a second contactor position by comparing the second closed contactor voltage and the second contactor open voltage to the bus voltage.

The foregoing features and elements may be combined in various combinations without exclusivity, unless expressly indicated otherwise. For example, aspects and/or embodiments of the present disclosure may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

FIG. 1 illustrates an aircraft including a propulsion system, in accordance with one or more embodiments of the present disclosure.
FIG. 2 is a diagrammatic representation of a hybrid-electric propulsion system for an aircraft.
FIG. 3 is a diagrammatic representation of a gas turbine engine embodiment that may be included in a hybrid-electric propulsion system.
FIG. 4 is a diagrammatic representation of a battery string.
FIG. 5 diagrammatically illustrates an electrical circuit that may be used within the present disclosure that includes a battery having a plurality of battery strings disposed in a parallel configuration.
FIG. 6 diagrammatically illustrates an electrical circuit that may be used within the present disclosure that includes a battery having a plurality of battery cells disposed in a parallel configuration.
FIG. 7 diagrammatically illustrates an electrical circuit that may be used within the present disclosure that includes a battery having a plurality of battery cells disposed in a parallel configuration.

### DETAILED DESCRIPTION

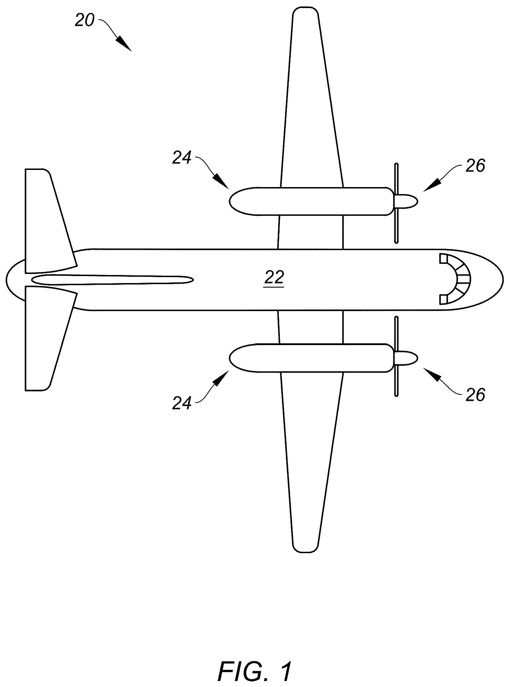

FIG. 1 illustrates a conventional fixed wing aircraft 20 that may utilize embodiments of the present disclosure. The aircraft 20 includes a fuselage 22 and a pair of nacelles 24. Each nacelle 24 houses a propulsion system that provides thrust for the aircraft 20. The propulsion system may be a hybrid-electric propulsion (HEP) system, or an all-electric propulsion system, or a fuel-cell-electric propulsion systems, or the like that utilizes a battery to store and produce electrical energy. Aspects of the present disclosure may also be equally applicable to aircraft power systems which are not part of a propulsion system, for example, an engine for an auxiliary power unit (APU). To facilitate the description herein, the present disclosure will be described as it may be used with or as part of a HEP system 26 but the present disclosure is not limited thereto. The present disclosure is not limited to use with fixed wing aircraft 20 and may be used with rotary-wing aircraft (e.g., a helicopter), tilt-rotor aircraft, tilt-wing aircraft, or another aerial vehicle, and the aircraft may be a manned aerial vehicle or an unmanned aerial vehicle (UAV, e.g., a drone).

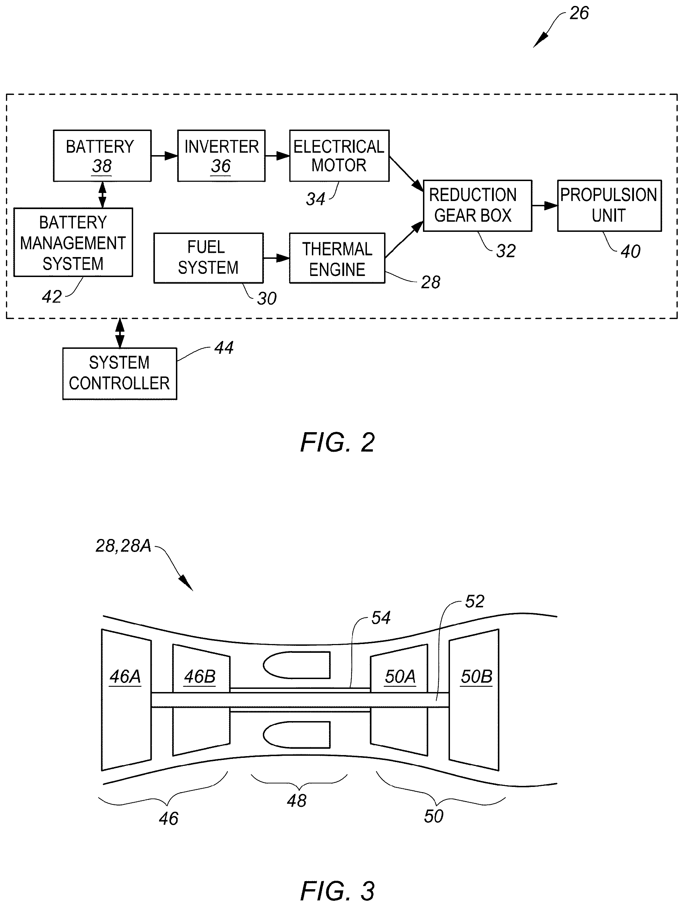

FIG. 2 diagrammatically illustrates an example of a hybrid-electric propulsion (HEP) system 26 that includes a thermal engine 28, a thermal engine fuel system 30, a reduction gear box 32 (RGB), an electric motor 34, an inverter 36, a battery 38, a propulsion unit 40, and a battery electrical management system 42. In some embodiments (as shown in FIG. 2), the HEP system 26 may include a system controller 44. The aforesaid HEP system 26 components are examples of components that may be included and the present disclosure is not limited to those shown in FIG. 2; e.g., fewer or more components may be included and/or different components may be included. The HEP system 26 configuration shown in FIG. 2 is a parallel configuration wherein the thermal engine 28 or the electric motor 34 alone may provide motive force to the reduction gear box 32, or the thermal engine 28 and the electric motor 34 may in combination provide motive force to the reduction gear box 32. The motive force provided to the reduction gear box 32 is used to drive the propulsion unit 40.

An example of a thermal engine 28 that may be used in the HEP system 26 is a gas turbine engine 28A. FIG. 3 diagrammatically illustrates a gas turbine engine 28A having a compressor section 46, a combustion section 48, and a turbine section 50. The compressor section 46 includes a low pressure compressor 46A and a high pressure compressor 46B. The turbine section 50 includes a high pressure turbine 50A and a low pressure turbine 50B. The low pressure turbine 50B is connected to low pressure compressor 46A by a low pressure shaft 52 and the high pressure turbine 50A is connected to high pressure compressor 46B by a high pressure shaft 54. In some instances (not shown), the gas turbine engine 28A may include a power turbine. Air drawn into the compressor section 46 is compressed and passed to the combustion section 48. Fuel is added to the compressed air flow and is combusted within the combustion section 48. The combustion products and any residual air are passed to the turbine section 50, powering the turbine section 50. The turbine section 50, in turn, provides motive force to drive the compressor section 46 and motive force to drive the reduction gear box 32 and propulsion unit 40; e.g., see FIG. 2. The present disclosure is not limited to any particular gas turbine engine 28A configuration. The thermal engine fuel system 30 provides fuel to the gas turbine engine 28A. The present disclosure is not limited to using any particular type of fuel within the HEP system 26.

Referring back to FIG. 2, the electric motor 34 may be an alternating current (AC) motor configured to rotationally drive a component. In some embodiments, more than one electric motor 34 may be included in the HEP system 26 to drive the propulsion unit 40.

The reduction gear box 32 is configured to accept a rotational drive input at an input rotational speed and torque and produce an output rotational drive at an output rotational speed and torque. Typically, the output rotational speed is less than the input rotational speed and the output torque is greater than the input torque. In the HEP system 26 example shown in FIG. 2, the reduction gear box 32 is configured to receive a pair of rotational drive inputs; e.g., from the thermal engine 28 and the electric motor 34.

The propulsion unit 40 may be configured to provide thrust (or power) and/or lift to the aircraft 20. An example of a propulsion unit 40 that may be used to provide power for a fixed-wing aircraft 20 is a propeller system. An example of a propulsion unit 40 that may be used to provide thrust for a fixed-wing aircraft is a turbofan system. An example of a propulsion unit 40 that may be used to produce lift for an aircraft (e.g., a rotary aircraft such as a helicopter) is a rotor system. The present disclosure is not limited to any particular type of propulsion unit 40.

The inverter 36 may be configured to transform electrical energy from the battery 38 (direct current - DC) into a form usable by the electric motor 34 (e.g., alternating current - AC) and to control the speed of the electric motor 34 by controlling voltage and frequency. The present disclosure is not limited to any particular inverter 36 configuration or electric motor 34 control configuration.

The term "system controller" as used herein refers to a device that may include any type of computing device, computational circuit, processor(s), CPU, computer, or the like capable of executing a series of instructions that are stored in memory. The instructions may include an operating system, and/or executable software modules such as program files, system data, buffers, drivers, utilities, and the like. The executable instructions may apply to any functionality described herein to enable the present disclosure system (or a system component) to accomplish the same algorithmically and/or coordination of system components. The system controller 44 may include or may be in communication with one or more memory devices. The present disclosure is not limited to any particular type of memory device, and the memory device may store instructions and/or data in a non-transitory manner. Examples of memory devices that may be used include read-only memory, random access memory, volatile memory, non-volatile memory, static memory, dynamic memory, flash memory, cache memory, and/or any device that stores digital information. The system controller 44 may be an independent component or it may be integrated within another controller present with the HEP system 26 (or aircraft 20) and that controller may be configured to perform the functionality detailed herein. The present disclosure is not limited to any particular controller architecture unless specifically stated herein.

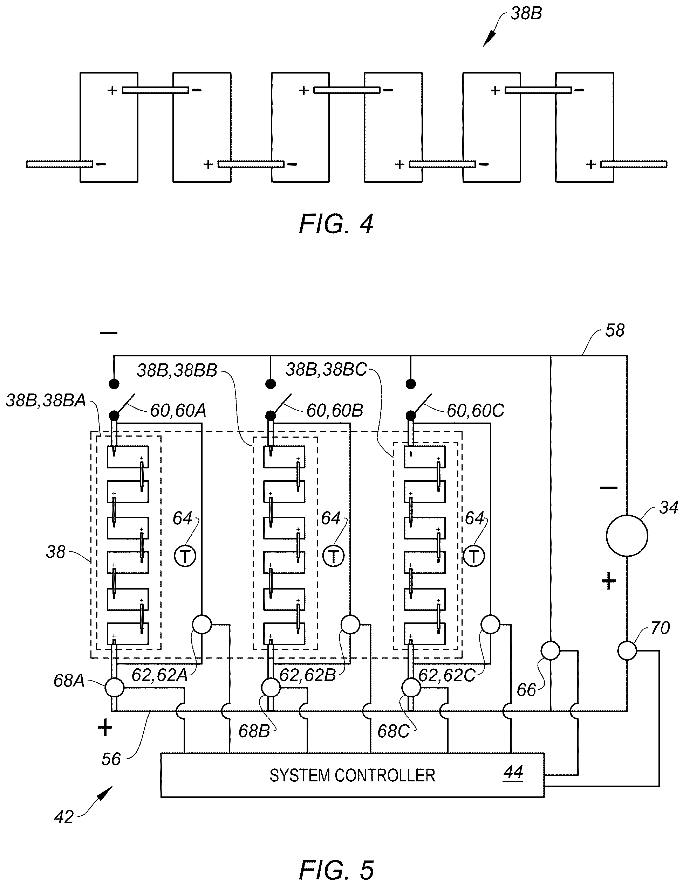

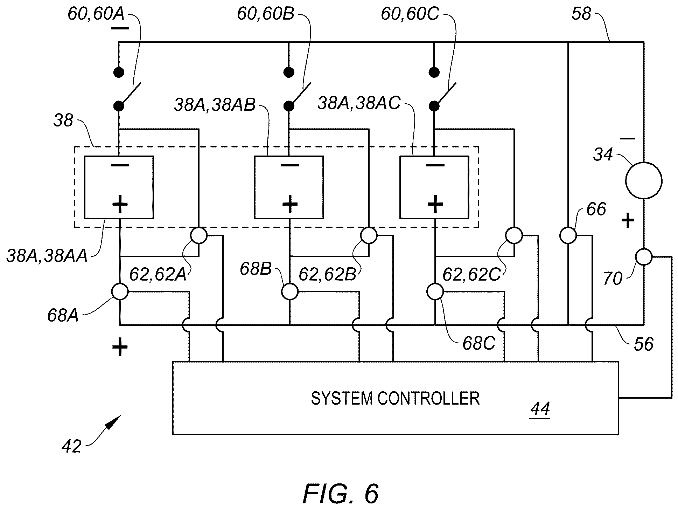

The term "battery" as used herein to refer to a device that generates electrical energy from chemical reactions and can be operated in a discharging mode (i.e., a mode wherein electrical energy is produced) and in a charging mode (i.e., a mode wherein electrical energy is stored). The battery 38 has a power storage capacity; i.e., the amount of electrical energy that the battery 38 can store and discharge. The present disclosure is not limited to any particular battery 38 form. In some embodiments, the battery 38 configuration may include battery cells 38A (e.g., see FIG. 6) that are configured in parallel pairs. In some embodiments, the battery 38 configuration may include battery strings 38B that are disposed in a parallel configuration; e.g., see FIG. 5. A battery string 38B may include a plurality of battery modules connected to one another in a series arrangement. Each battery module is the structure within which the chemical reaction occurs that produces electrical energy or that can be "charged" by receiving and storing electrical energy. A battery cell 38A and a battery string 38B each includes a positive pole and a negative pole for attachment to an electrical circuit. FIG. 4 diagrammatically illustrates a battery string 38B that includes a plurality of battery modules (e.g., six) connected in series. The present disclosure is not limited to any particular battery string 38B configuration; e.g., no limit on the number of battery modules within a battery string 38B.

FIG. 5 diagrammatically illustrates an electrical circuit that may be used within the present disclosure that includes a battery 38 having a plurality of battery strings 38B (e.g., three) disposed in a parallel configuration. The positive lead from each battery string 38B is connected to a positive bus connector 56 and the negative lead from each battery string 38B is connected to a negative bus connector 58. In the circuit shown in FIG. 5, a contactor 60 is disposed in line between each battery string 38B and the negative bus connector 58. Alternatively, a contactor 60 may be disposed in line between each battery string 38B and the positive bus connector 56 or a first contactor 60A in line between each battery string 38B and the positive bus connector 56 and a second contactor 60B between the battery string 38B and the negative bus connector 58. The bus connectors 56, 58 may be any structure (e.g., wires, cables, strips, and the like) that is configured to conduct electricity in a manner adequate to perform the functions described herein. The present disclosure is not limited to any particular bus connector 56, 58 configuration.

FIG. 6 diagrammatically illustrates an electrical circuit that may be used within the present disclosure that includes a battery 38 having a plurality of battery cells 38A (e.g., three) disposed in a parallel configuration. The positive lead from each battery cell 38A is connected to a positive bus connector 56 and the negative lead from each battery cell 38A is connected to a negative bus connector 58. Like the circuit shown in FIG. 5, the circuit shown in FIG. 6 may have a contactor 60 disposed in line between each battery cell 38A and the negative bus connector 58, or a contactor 60 disposed in line between each battery cell 38A and the positive bus connector 56, or a contactor 60 in line between each battery cell 38A and the positive bus connector 56 and another contactor 60 between the battery cell 38A and the negative bus connector 58. To facilitate the description herein, a battery cell 38A or a battery string 38B may be referred to generically as a "battery unit".

The parallel configurations of battery strings 38B and battery cells 38A shown in FIGS. 5 and 6 respectively are examples provided herein to facilitate the description of the present disclosure; e.g., the present disclosure may be used in any battery 38 structure that includes multiple battery units (e.g., battery cells 38A, modules, battery strings 38B, or the like) disposed in a parallel configuration.

The contactors 60 are selectively configurable (e.g., switchable) in a closed configuration to conduct an electrical current or in an open configuration to interrupt an electrical current. The contactors 60 may include electrically-controlled relays or switches which may be controlled by an electrical control signal to position the respective contactors 60 in the open configuration or in the closed configuration. The present disclosure is not limited to the any particular contactor 60 configuration.

The battery electrical management system 42 may include hardware, controls, and/or a controller and the like for controlling operation of the battery system; e.g., for controlling charging and/or discharging, for voltage balancing a plurality of battery strings 38B, and the like. The battery electrical management system 42 may be configured to determine and provide status information such as a state of charge (e.g., power storage capacity remaining) or health of the battery system, to monitor battery voltage and/or current levels, to detect faults, and other appropriate operational parameters.

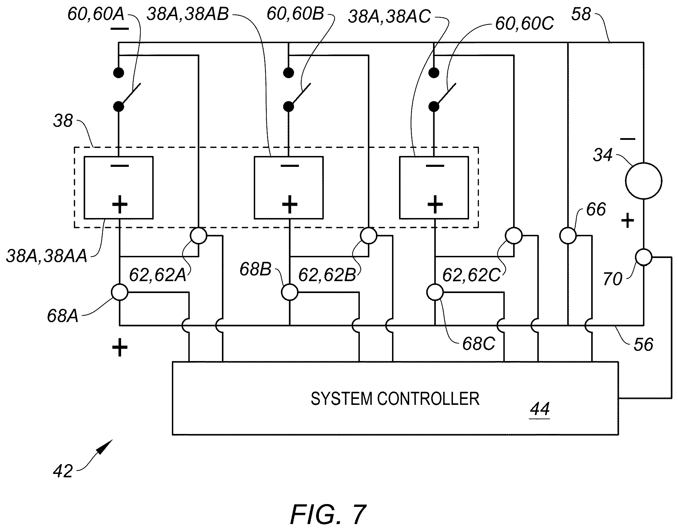

In the embodiment shown in FIG. 5, the battery electrical management system 42 includes a voltage sensor 62 disposed to sense the voltage across each battery string 38B; e.g., a first voltage sensor 62A disposed to sense the voltage across the first battery string 38BA, a second voltage sensor 62B disposed to sense the voltage across the second battery string 38BB, and a third voltage sensor 62C disposed to sense the voltage across the third battery string 38BC. In the embodiment shown in FIG. 5, the battery electrical management system 42 also includes a bus voltage sensor 66 disposed to sense the voltage between the positive bus connector 56 and the negative bus connector 58. In the embodiment shown in FIG. 6, the battery electrical management system 42 includes a voltage sensor 62 disposed to sense the voltage across each battery cell 38A; e.g., a first voltage sensor 62A disposed to sense the voltage across the first battery cell 38AA, a second voltage sensor 62B disposed to sense the voltage across the second battery cell 38AB, and a third voltage sensor 62C disposed to sense the voltage across the third battery cell 38AC. The battery electrical management system 42 shown in FIG.6 also includes a bus voltage sensor 66 disposed to sense the voltage between the positive and negative bus connectors 56, 58. In FIGS. 5 and 6, the voltage sensors 62A-C are disposed across the battery strings 38B / battery cells 38A and the contactors 60 are disposed outside of the voltage sensor 62A-C connections. In some embodiments, in each leg of the parallel configuration the voltage sensor 62 may be disposed across the battery string 38B (or battery cell 38A) and the contactor(s) 60 in that leg; e.g., see FIG. 7. The battery electrical management system 42 embodiments shown in FIGS. 5 and 6 also includes a current sensor 68A, 68B, 68C disposed in each battery unit leg to sense current passing through that battery unit leg, and a bus current sensor 70.

In some embodiments, the system 42 may include include one or more pre-charge contactors and one or more resistors disposed within the circuit between a battery unit (e.g., battery cell 38A or battery string 38B) and a bus connector 56, 58. In some embodiments, the system 42 may include one or more pre-charge contactors and one or more resistors and a main contactor disposed within the circuit between a bus connector 56, 58 and the electric motor 34.

The HEP system 26 may include an electrical distribution system that electrically interconnects components of the HEP system 26. The electrical distribution system may include includes switchgear, cables, wires, breakers, switches, contactors, and/or other electrical components to effect the transfer of electrical power between electrical components within the HEP system 26.

In some embodiments, the present disclosure may include sensors that provide data that is pertinent to battery state of charge and/or battery health. For example, in some embodiments the battery electrical management system 42 may include a plurality of temperature sensors 64 (see FIG. 5) configured to measure the temperature of the battery 38; e.g., measure the temperature on, adjacent, or proximate the battery 38. In particular, the temperature sensors 64 may be configured to measure localized temperatures at (e.g., within, on, adjacent, or proximate) battery cells 38A, or battery strings 38B of the battery 38. In some embodiments, temperature sensors 64 may be configured and disposed to sense the localized temperature at (e.g., within, on, adjacent, or proximate) each battery module within a battery string 38B of the battery 38. Temperature can be a factor in battery performance, charging, and voltage control; e.g., at higher temperatures, there is dramatically more chemical activity inside a battery 38 than at lower temperatures. The present disclosure is not limited to any particular battery 38 temperature sensing arrangement.

Aircraft propulsion systems (e.g., HEP systems, all-electric propulsion systems, fuel-cell-electric propulsion systems, or the like) that utilize a battery 38 to store and produce electrical energy often require a battery 38 structure that includes multiple battery units; e.g., multiple battery cells 38A, modules, battery strings 38B, or the like. It is known to dispose these battery units in a parallel configuration. A single voltage sensor disposed to measure voltage across the parallel configuration can provide battery state information relating to the entire parallel configuration but does not provide specific information regarding the state of each battery unit (e.g., battery cell 38A, module, battery string 38B, or the like) within the parallel configuration or the contactors 60 within the parallel legs of the circuit. As a result, if the voltage sensor detects an abnormality within the parallel configuration, it becomes necessary to either replace the entire parallel battery 38 arrangement or to perform diagnostics on each battery unit (e.g., battery cell 38A, module, battery string 38B, or the like) within the parallel configuration to identify the abnormal battery unit. Replacing the entire parallel configuration may involve the removal of one or more individual battery units that are operating abnormally as well as the removal of one or more individual battery units that are operating normally. Hence, this approach may lead to unnecessary cost and waste. Performing diagnostics on each battery unit (e.g., battery cell 38A, module, battery string 38B, or the like) within the parallel configuration can be time consuming and expensive.

In addition, voltage sensors can fail on occasion. If a battery system includes a single voltage sensor disposed to measure voltage across a parallel configuration and that voltage sensor fails, then the aircraft propulsion system may be blind regarding the health or state of that parallel battery configuration. A redundant backup voltage sensor may account for the possibility of a primary voltage sensor failing, but including the redundant backup voltage sensor likely requires additional wiring and sensor circuits that add weight, complexity and cost. Like the primary voltage sensor, the redundant backup voltage sensor also provides battery state or health information relating to the entire parallel configuration and does not provide specific information regarding the state of each battery unit (e.g., battery cell 38A, module, battery string 38B, or the like) or contactor 60 within the parallel configuration.

The present disclosure system permits evaluation of the individual battery units 38A, 38B, the contactor(s) 60, and the voltage sensors 62 within the parallel configuration in several different ways. For example, when the contactors 60 within the respective legs are closed and current is drawn by the electric motor 34, the voltage may be sensed within each parallel leg via the voltage sensor 62 in that leg. The sensed voltage values within the legs may then be compared to one another. To the extent there are differences in voltage between the respective legs of the parallel configuration, those differences may be evaluated relative to a threshold difference value; e.g., a predetermined voltage value. The threshold difference value may take into account factors such as, but not limited to, acceptable accuracy of the voltage sensors 62, predetermined electrical resistance within the legs of the parallel configuration (other than the contactor 60), or contactor 60 resistance. If the difference in voltage between a respective leg of the parallel configuration and the other legs in the parallel configuration exceeds the threshold, the system may produce a "flag" (i.e., a fault indicator such as a warning light or the like) that there is a discrepancy in that battery leg; e.g., a faulty voltage sensor 62, a malfunctioning contactor 60, or the like. The difference in voltage may not provide specific information regarding the basis for the difference in voltage, but nevertheless will provide information that an issue may exist.

In those system configurations that include a bus voltage sensor 60, it may be possible to provide more specific information. For example, if the system is configured such that the voltage in a leg of the parallel configuration is sensed across the battery unit but not across both the battery unit and the contactor 60 (e.g., see FIGS. 5 and 6), the sensed voltage across the battery unit in a given leg may be compared to the voltage sensed by the bus voltage sensor 66 between the positive and negative bus connectors 56, 58; i.e., the "bus voltage". The aforesaid comparison may provide information regarding the status of the contactor 60 in that leg of the parallel configuration; e.g., the difference between the voltage across the battery unit and the bus voltage yields the difference in voltage across the respective contactor 60. The electrical resistance of the contactor 60 can be determined and evaluated by dividing the voltage across the contactor 60 divided by the current through the contactor 60. The current through the contactor 60 may be determined via the respective current sensor 68A, 68B, 68C. The determined resistance of the contactor 60 may be evaluated relative to a predetermined threshold value, or evaluated via a comparison with the determined electrical resistance of the other contactors 60 in the parallel configuration, or the like.

Information regarding the status of a given contactor 60 in a leg of the parallel configuration may also be provided by sensing the voltage and current in that leg (when the motor 34 is drawing current) when the contactor 60 is controlled to be in an open configuration and in a closed configuration. For example, if no current is sensed within the leg in both the contactor 60 open and closed configurations, then that would be an indicator of contactor 60 malfunction or contactor 60 control malfunction.

Information regarding the status of the voltage sensors 62 may also be provided by sensing the voltage across the battery unit in each leg of the parallel configuration using the respective voltage sensor 62A, 62B, 62C when no current is by the electric motor 34. The same voltage measurement may be performed in each leg of the parallel configuration. Each voltage sensor 62 within the system will likely possess an accuracy range (representative of +/- X volts). The accuracy ranges of the voltages sensors 62 may be considered when evaluating the status of the voltage sensors 62.

Information regarding the status of the voltage sensors 62 may also be provided by sensing the voltage across the battery unit in each leg of the parallel configuration using the respective voltage sensor 62A, 62B, 62C when no current is by the electric motor 34 and the contactors 60 are open, sensing the voltage across the battery unit in each leg of the parallel configuration using the respective voltage sensor 62A, 62B, 62C when no current is by the electric motor 34 and the contactors 60 are closed, and sensing the bus voltage. The "no current, open contactor" voltage, the "no current, closed contactor" voltage (for each leg), and the bus voltage can be used to evaluate the presence or absence of voltage sensor measurement error as distinguished from battery voltage imbalance. Specifically, the difference between the "no current, open contactor" voltage and the bus voltage, and the difference between the "no current, closed contactor" voltage and the bus voltage (for each leg), can be compared to provide information regarding the presence or absence of voltage sensor measurement error greater than a predetermined threshold.

The aforesaid evaluations of the sensed voltages and/or currents may be accomplished via stored instructions executed by the system controller 44 or in some cases via an electric circuit such as a voltage comparator and lamps. Abnormal voltage and/or current values may be flagged for further evaluation.

In some aircraft 20 applications that include a parallel battery 38 configuration, the battery units within a parallel configuration may be subject to different temperature environments. The same type of battery units disposed at different temperatures may be a factor that affects the voltage across the respective different temperature battery units within the parallel configuration; i.e., another parameter to be considered in the evaluation. Input from temperature sensors 64 associated with the individual battery units within the parallel configuration may be used in the battery unit evaluations; e.g., via stored instructions executed by the system controller 44.

While the principles of the disclosure have been described above in connection with specific apparatuses and methods, it is to be clearly understood that this description is made only by way of example and not as limitation on the scope of the disclosure. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected or the like may include permanent, removable, temporary, partial, full and/or any other possible attachment option.

No element, component, or method step in the present disclosure is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the disclosures may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the disclosures--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements. It is further noted that various method or process steps for embodiments of the present disclosure are described herein. The description may present method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

## Claims

1. A method of monitoring a battery system (42) utilized within an aircraft propulsion system (26), the method comprising:
providing a parallel electrical circuit having a first battery unit (38A) and a first electrical contactor (60A) disposed in a first leg of the parallel electrical circuit, a second battery unit (38B) and a second electrical contactor (60B) disposed in a second leg of the parallel electrical circuit, a positive bus connector (56) electrically connected to the first leg and the second leg, a negative bus connector (58) electrically connected to the first leg and the second leg, and an electrical device (34) electrically connected to the positive bus connector (56) and the negative bus connector (58), and controllable to draw electrical current through the parallel electrical circuit;
wherein the first electrical contactor (FEC) (60A) is controllable to be in an FEC closed configuration and an FEC open configuration; and
wherein the second electrical contactor (SEC) (60B) is controllable to be in an SEC closed configuration and an SEC open configuration; and
controlling the first electrical contactor (60A) to be in the FEC closed configuration, and controlling the second electrical contactor (60B) to be in the SEC closed configuration;
using a first voltage sensor (62A) to determine a first voltage across the first battery unit (38A) within the first leg when the first electrical contactor (60A) is in the FEC closed configuration;
using a second voltage sensor (62B) to determine a second voltage across the second battery unit (38B) within the second leg when the second electrical contactor (60B) is in the SEC closed configuration; and
monitoring the battery system (42) by determining a difference between the first voltage and the second voltage, and producing a fault indicator if the first difference or the second difference exceeds a predetermined threshold.

2. The method of claim 1, wherein the first electrical contactor (60A) is disposed in the first leg between the first battery unit (38A) and the positive bus connector (56), and the second electrical contactor (60B) is disposed in the second leg between the second battery unit (38B) and the positive bus connector (56).

3. The method of claim 2, wherein the first voltage sensor (62A) is in electrical communication with the first leg between a pole of the first battery unit (38A) and the first electrical contactor (60A), and the second voltage sensor (62B) is in electrical communication with the second leg between a pole of the second battery unit (38B) and the second electrical contactor (60B).

4. The method of claim 3, wherein the method further comprises using a bus voltage sensor (66) to determine a bus voltage between the positive bus connector (56) and the negative bus connector (58); and
determining a first contactor voltage by subtracting the first voltage from the bus voltage.

5. The method of claim 4, wherein the method further comprises determining a first contactor resistance by sensing a first leg current using a first leg current sensor (68A), and dividing the first contactor voltage by the first leg current.

6. The method of any of claims 2 to 5, wherein the method further using a or the bus voltage sensor (66) to determine a or the bus voltage between the positive bus connector (56) and the negative bus connector (58); and determining a second contactor voltage by subtracting the second voltage from the bus voltage.

7. The method of claim 6, wherein the method further comprises determining a second contactor resistance by sensing a second leg current using a second leg current sensor (68B), and dividing the second contactor voltage by the second leg current.

8. The method of claim 1, wherein the first electrical contactor (60A) is disposed in the first leg between the first battery unit (38A) and the positive bus connector (56) or between the first battery unit (38A) and the negative bus connector (58), and the second electrical contactor (60B) is disposed in the second leg between the second battery unit (38B) and the positive bus connector (56) or between the second battery unit (38B) and the negative bus connector (58).

9. The method of claim 1, wherein the first electrical contactor (60A) is disposed in the first leg between the first battery unit (38A) and the negative bus connector (58), and the second electrical contactor (60B) is disposed in the second leg between the second battery unit (38B) and the negative bus connector (58).

10. The method of claim 9, wherein the first voltage sensor (62A) is in electrical communication with the first leg between a pole of the first battery unit (38A) and the first electrical contactor (60A), and the second voltage sensor (62B) is in electrical communication with the second leg between a pole of the second battery unit (38B) and the second electrical contactor (60B).

11. The method of any preceding claim, further comprising controlling the electrical device (34) to draw electrical current through the parallel electrical circuit; and
wherein a bus voltage sensor (66) is used to determine a bus voltage when the electrical device (34) is drawing electrical current through the parallel electrical circuit.

12. The method of any preceding claim, further comprising using a or the bus voltage sensor (66) to determine a or the bus voltage between the positive bus connector (56) and the negative bus connector (58); and
wherein the step of monitoring the battery system (42) includes determining a first difference between the first voltage and the bus voltage, and determining a difference between the second voltage and the bus voltage, and producing a fault indicator if the first difference or the second difference exceeds a predetermined threshold.

13. A method of inspecting electrical contactors (60A, 60B, 60C) in a battery system (42) utilized within an aircraft propulsion system (26), the method comprising:
wherein the battery system (42) includes a parallel electrical circuit having a first battery unit (38A) and a first electrical contactor (60A) disposed in a first leg of the parallel electrical circuit, a second battery unit (38B) and a second electrical contactor (60B) disposed in a second leg of the parallel electrical circuit, a positive bus connector (56) electrically connected to the first leg and the second leg, a negative bus connector (58) electrically connected to the first leg and the second leg, and an electrical device (34) electrically connected to the positive bus connector (56) and the negative bus connector (58), and controllable to draw electrical current through the parallel electrical circuit;
controlling the first electrical contactor (FEC) (60A) to be in an FEC closed configuration, and controlling the second electrical contactor (SEC) (60B) to be in an SEC closed configuration;
using a first voltage sensor (62A) to determine a first voltage across the first battery unit (38A) within the first leg when the electrical device (34) is drawing electrical current through the parallel electrical circuit;
using a second voltage sensor (62b) to determine a second voltage across the second battery unit (38B) within the second leg;
using a bus voltage sensor (66) to determine a bus voltage between the positive bus connector (56) and the negative bus connector (58);
determining a first contactor voltage using the first voltage and the bus voltage; and
determining a second contactor voltage using the second voltage and the bus voltage.

14. The method of claim 13, wherein:
the first electrical contactor (60A) is disposed in the first leg between the first battery unit (38A) and the positive bus connector (56), and the second electrical contactor (60B) is disposed in the second leg between the second battery unit (38B) and the positive bus connector (56), optionally wherein the first voltage sensor (62A) is in electrical communication with the first leg between a pole of the first battery unit (38A) and the first electrical contactor (60A), and the second voltage sensor (62B0 is in electrical communication with the second leg between a pole of the second battery unit (38B) and the second electrical contactor (60B); and/or
the method further comprises determining a first contactor voltage by subtracting the first voltage from the bus voltage, optionally wherein the method further comprises determining a first contactor resistance by sensing a first leg current using a first leg current sensor (68A) in line within the first leg, and dividing the first contactor voltage by the first leg current; and/or
the method further comprises determining a second contactor voltage by subtracting the second voltage from the bus voltage, optionally wherein the method further comprises determining a second contactor resistance by sensing a second leg current using a second leg current sensor (68B) in line within the second leg, and dividing the second contactor voltage by the second leg current.

15. A method of inspecting contactor position in a battery system (42) utilized within an aircraft propulsion system (26), the method comprising:
wherein the battery system (42) includes a parallel electrical circuit having a first battery unit (38A) and a first electrical contactor (60A) disposed in a first leg of the parallel electrical circuit, a second battery unit (38B) and a second electrical contactor (60B) disposed in a second leg of the parallel electrical circuit, a positive bus connector (56) electrically connected to the first leg and the second leg, a negative bus connector (58) electrically connected to the first leg and the second leg, and an electrical device (34) electrically connected to the positive bus connector (56) and the negative bus connector (58), and controllable to draw electrical current through the parallel electrical circuit;
using a first voltage sensor (62A) to determine a first closed contactor voltage across the first battery unit (38A) within the first leg when the first electrical contactor (FEC) (60A) is in an FEC closed configuration;
using a second voltage sensor (62B) to determine a second closed contactor voltage across the second battery unit (38B) within the second leg when the second electrical contactor (SEC) (60B) is in an SEC closed configuration;
using the first voltage sensor (62A) to determine a first open contactor voltage across the first battery unit (38A) within the first leg when the first electrical contactor (60A) is in an FEC open configuration;
using the second voltage sensor (62B) to determine a second open contactor voltage across the second battery unit (38B) within the second leg when the second electrical contactor (60B) is in an SEC open configuration;
using a bus voltage sensor (66) to determine a bus voltage between the positive bus connector (56) and the negative bus connector (58);
inspecting a first contactor position by comparing the first closed contactor voltage and the first open contactor voltage to the bus voltage; and
inspecting a second contactor position by comparing the second closed contactor voltage and the second open contactor voltage to the bus voltage.
